Europäisches Patentamt

European Patent Office

Office européen des brevets

(11) Publication number: **0 265 886 B1**

## EUROPEAN PATENT SPECIFICATION

(45) Date of publication of patent specification: **07.04.93**  (51) Int. Cl.⁵: **C23C 14/28**, H01L 39/24, B22F 9/04

(21) Application number: **87115669.1**

(22) Date of filing: **26.10.87**

(54) **Process for forming an ultrafine-particle film.**

(30) Priority: **27.10.86 JP 253817/86**

(43) Date of publication of application:
**04.05.88 Bulletin 88/18**

(45) Publication of the grant of the patent:
**07.04.93 Bulletin 93/14**

(84) Designated Contracting States:
**DE FR GB**

(56) References cited:
**US-A- 4 281 030**

**PATENT ABSTRACTS OF JAPAN, vol. 2, no. 89 (C-18)(1366), 21 July 1978& JP-A-5348088**

**PATENT ABSTRACTS OF JAPAN, vol. 6, no. 95 (E-110)(1366), 03 June 1982 & JP-A-5727079**

**PATENT ABSTRACTS OF JAPAN, vol. 10, no. 252 (C-369)(2308), 29 August 1986 & JP-A-6179765**

(73) Proprietor: **HITACHI, LTD.**
**6, Kanda Surugadai 4-chome**
**Chiyoda-ku, Tokyo 101(JP)**

(72) Inventor: **Araya, Takeshi**
**10-29, Gakuencho-1-chome**
**Higashikurume-shi(JP)**
Inventor: **Matsunawa, Akira**
**1-2-904, Takahatacho**
**Nishinomiya-shi(JP)**
Inventor: **Katayama, Seiji**
**9-A-2-408, Yamadanishi-2-chome**
**Suita-shi(JP)**
Inventor: **Hioki, Susumu**
**24-2, Midorigaoka**
**Kashiwa-shi(JP)**
Inventor: **Haneda, Mitsuaki**
**114-8, Asahimachi Tomobemachi**
**Nishiibaraki-gun Ibaraki-ken(JP)**
Inventor: **Okada, Ryoji Tsukuba Hausu 1-305**
**2625-3 Shimoinayoshi Chiyodamura**
**Niihari-gun Ibaraki-ken(JP)**

PATENT ABSTRACTS OF JAPAN, vol. 8, no. 236 (C-249)(1673), 30 October 1984 & JP-A-59116373

(74) Representative: **Finck, Dieter et al**
**Patentanwälte v. Füner, Ebbinghaus, Finck**
**Mariahilfplatz 2 & 3**
**W-8000 München 90 (DE)**

**EP 0 265 886 B1**

**Description**

The invention relates to a process for forming an ultrafine particle film on a substrate.

JP 61-79765 A describes a vacuum vessel in which a rotating disk of a material for vapour deposition is arranged and heated by laser energy, which laser is linearly oscillating across the circumferential surface of the disk by means of a mirror. The laser energy provides evaporation of the material of the disk. The vapour is deposited on the surface of the substrate which is respectively arranged within the vacuum vessel facing the position of vapour production on the disk.

By this evaporation a film is deposited over the entire surface of the substrate with a uniform thickness and a very smooth surface.

US-A-4 281 030 describes a vacuum chamber in which a target for a material to be evaporated by means of a laser is arranged opposite to a substrate to which the vapour of the target is directed into an area, which is premelted also by laser energy. The laser intensity with regard to the target is $10^8$ to $10^9$ $W/cm^2$. In the vacuum of about $10^{-3}$ Pa a particle flux consisting of ions is produced having a speed of approximately $10^5$ m/s.

Because of the high vacuum in the vacuum vessels of the prior art, the mean free path length for the produced ions is 5 meters and more, which means that there are nearly no collisions of the ultrahigh-speed flux of the ions from the target to the substrate which results in a film having a smooth surface without any particle character and which consists only of the components of the target.

For producing ultrafine particles by means of arc, there has heretofore been utilized a mechanism in which a hydrogen-containing gas is dissolved in a molten metal, subjected to convection current therein, and liberated therefrom, as disclosed, for example, in US-A-4 482 134 and Japanese patent publication no. 44725/82.

As methods for forming the thus obtained ultrafine particles into a film, there are known a method comprising coating a solution prepared by dissolving the particles in a solvent, and a method comprising spraying the particles by utilizing a gas flow.

In the above conventional production of ultrafine particles, the production efficiency is not taken into consideration. The conventional film forming methods described above have their respective defects as follows: the former method hardly permits formation of a film of high purity, while the latter method requires a complicated apparatus.

The object of this invention is to provide a process for forming an ultrafine particle film of high purity efficiently and easily.

This object is achieved by a process for forming an ultrafine particle film on a substrate wherein the surface of a raw material is irradiated with laser energy from $10^4$ to $10^7$ $W/cm^2$ in a predetermined atmosphere having a pressure of 1.3 x $10^4$ to 5 x $10^5$ Pa, wherein a plume-shaped high-speed stream of shining high-density vapour of metal or other material is generated, in which stream the ultrafine particles condense with a particle size of 5 to 65 nm, and wherein the substrate is exposed to said stream whereby the film of ultrafine particles is formed on said substrate.

Preferably the substrate is previously heated.

Advantageously said predetermined atmosphere includes a gas component which is reacted with said plume-shaped stream of vapour and/or an intermediate product of the film formation or said film, whereby a desired compound or alloy film is obtained on said substrate.

The used atmospheric conditions include atmosphere pressure, atmosphere gas, a material to be irradiated with laser energy which is a raw material for ultrafine particles, etc. When the atmosphere pressure is properly selected, ultrafine particles can be formed into a film so as to adjust their particle diameter distribution to a predetermined one. When the atmosphere gas is properly selected, a desired compound or a desired alloy film can be obtained by the reaction of this gas component with the plume and/or an intermediate product of the film formation or the film formed.

The raw material for ultrafine particles is not critical, and by proper selection thereof, a desired metal, alloy or nonmetal film can be formed. Furthermore, it is also possible to form a film of a mixture of a metal and a compound by properly selecting an alloy material and an atmosphere gas.

This invention is applicable to superconducting thin films composed of ultrafine particles. In this case, suitable raw materials are sintered bodies of oxide superconductors or the corresponding alloys, or ceramics and alloys having an element ratio different from that of a film to be formed which are used for attaining a desired composition of film. In forming a superconducting thin film, it is preferable to cool a film rapidly or slowly after heating, and as a heat source for the heating, a heater or a high-frequency induction coil can be used. Slow cooling (e.g., 200°C/hr) is often more effective. In this case, as substrates, there may be exemplified $A\ell_2O_3$ substrates, MgO substrates, $SrTiO_3$ single crystal substrates, Si substrates, etc.

3

When a raw material is irradiated with laser energy under conditions where the plume phenomenon occurs, a large amount of ultrafine particles are rapidly produced. A plume containing a large amount of ultrafine particles (e.g., metal vapor) moves at a high speed, and therefore when a substrate is exposed thereto, the plume adheres to the substrate strongly to form a film. When the substrate is preheated, the adhesive strength is increased.

This invention permits formation of various ultrafine particles into a film immediately after their production, and hence is effective in that an ultrafine-particle film can be obtained with a high purity and a high efficiency.

Embodiments of this invention are described below with reference to the drawings.

Fig. 1 is a schematic view of an apparatus for forming an ultrafine particle film to which one embodiment of this invention has been applied.

Fig. 2 is a characteristic graph showing the relationship between the distance from the focus of a condensing lens and laser energy.

Fig. 3 is a characteristic graph showing the relationship among the distance from the focus, the starting time of generation of a plume, and the propagation velocity of the top of the plume.

Fig. 4 is a characteristic graph showing the relationship between atmosphere pressure and the propagation velocity of the top of the plume.

Fig. 5 is a characteristic graph illustrating the moving velocity of the plume and shows the relationship between the height of the top of the plume and time.

Fig. 6 is a characteristic graph showing the relationship between laser energy and the generation rate of ultrafine particles.

Fig. 7 is a characteristic graph showing relationships between the generation rate of ultrafine particles and evaporated amount established for various raw materials.

Fig. 8 is a characteristic graph showing the relationship between atmosphere pressure and the generation rate.

Fig. 9 and Fig. 10 are characteristic graphs showing the influence of atmosphere pressure on the particle diameter.

Fig. 11 is an enlarged schematic view of the vicinity of a base material which shows another embodiment of this invention.

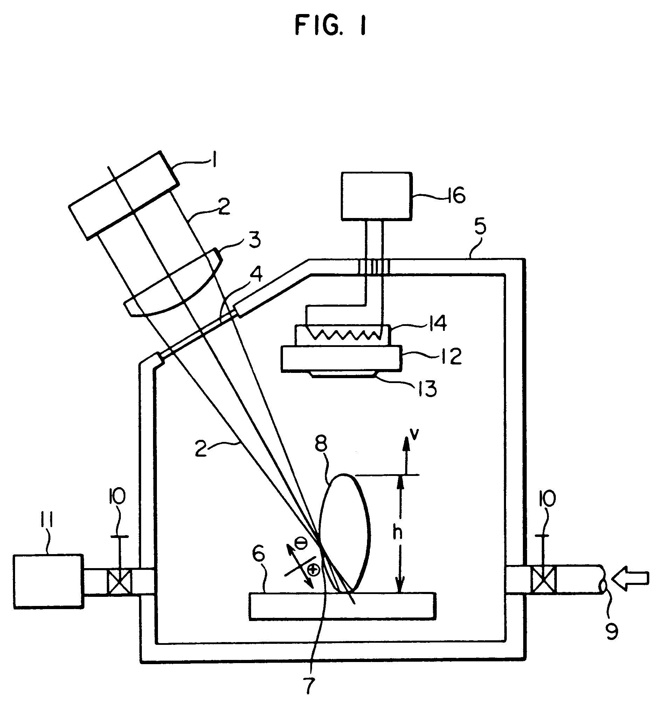

Fig. 1 shows one example of structure of an apparatus for irradiating the surface of a raw material under conditions where a plume is generated, and adhering the thus generated plume to the surface of a base material or substrate. In this embodiment, a YAG laser was used as laser source 1. Laser beams 2 emitted are converged by a condensing lens 3, pass through a glass plate 4, and enter an ultrafine-particle film forming chamber 5. The laser beams 2 are casted on a raw material 6 placed near the center of the bottom of the ultrafine-particle film forming chamber 5. The condenser lens 3 is intended to condense the laser beams 2 emitted from the laser source 1, and the distance from the focus is defined so as to have a minus value on the condensing lens 3 side or a plus value on the raw material 6 side both in relation to the focus position 7.

When the laser energy E (joule/pulse) applied to the surface of the raw material 6 is too high, a large amount of spatter is generated, while when it is too low, a small amount of metal is evaporated but is difficult to observe clearly with the naked eye or by photography. When an appropriate energy is applied, a plume 8 containing a large amount of ultrafine particles is observed.

The term "plume" used herein means high-density vapor of metal and the like from the surface of a raw material by irradiation of said surface with laser energy or the like which vapor shines and is observed as shown by the symbol 8 in Fig. 1.

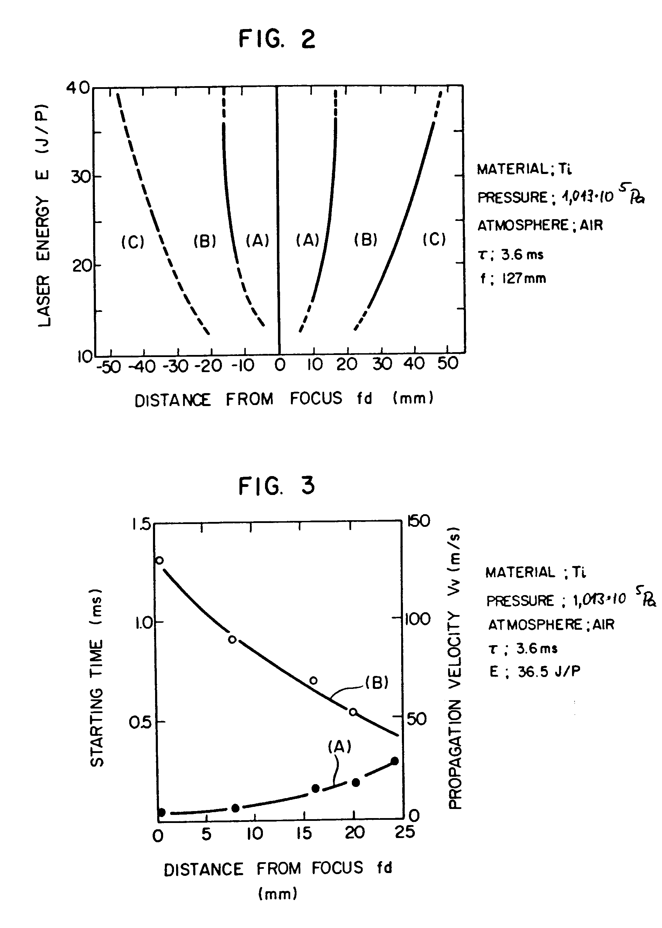

The relationship between laser energy satisfying the generation conditions of the plume 8 and the distance $f_d$ from the focus to the surface of a raw material is as shown in Fig. 2, in which (A) shows a region where spatter is generated concomitantly; (B) shows a region where only plume is generated; and (C) shows a region where no plume is generated. This relationship varies depending on the kind and surface condition of the raw material 6, the kind of atmosphere gas, and atmosphere pressure. In this embodiment, titanium (Ti) was used as a raw material, the atmosphere pressure P in the ultrafine-particle film forming chamber 5 was adjusted to one atmospheric pressure, and the pulse period ($\tau$) of the laser beams 2 was adjusted to 3.6 ms. The focal length f of the condensing lens 3 was 127 mm, and the atmosphere gas was air. As a result of research for various raw materials, laser energy to be applied to the surface of a raw material for generating the plume was found to range from $10^4$ to $10^7$ W/cm$^2$.

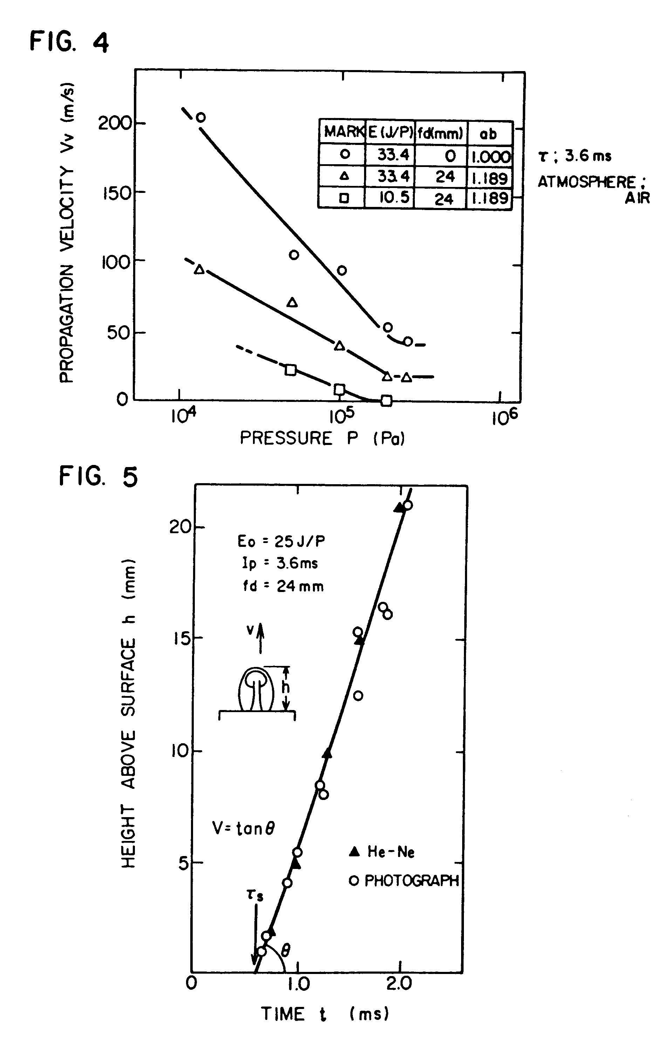

The generation of the plume 8 requires a period of 0.05 to 0.3 ms after irradiation with laser energy E, as shown by the curve (A) in Fig. 3. After this slight time lag, evaporation begins and the plume 8 moves as a high-speed vapor stream. This time (the starting time of the generation) varies depending on the intensity of the energy applied, namely, the distance from focus fd. The propagation velocity Vv of the top of the plume 8 generated varies greatly depending on the applied energy E and the atmosphere pressure P, as shown by the curve (B) in Fig. 3 and in Fig. 4. The applied energy E and the atmosphere pressure P affect the generation rate and particle diameter of ultrafine particles, etc.

The symbol $a_b$ in Fig. 4 denotes the ratio of the distance between the lens 3 and the raw material 6 to the focal length f of the lens 3. In Fig. 3, the applied energy E was adjusted to 36.5 J/P and other conditions were the same as in Fig. 2. In Fig. 4, $\tau$ was adjusted to 3.6 ms, the atmosphere gas was air, and E, fd and $a_b$ were adjusted so as to be as shown in Fig. 4.

Fig. 5 illustrates the way in which the plume 8 moves as a high-speed vapor stream. During the movement of the plume 8 composed of metal vapor, evaporated atoms are condensed in the space to form ultrafine particles.

The movement velocity of the top of the plume is shown by the slope in Fig. 5 ($v = \tan\theta$), and in this case, $v = 15$ m/s. Although the movement velocity varies depending on laser irradiation conditions, raw material, atmosphere pressure, etc., examples thereof are shown in Table 1.

Table 1

| Raw material 6 | Ti | $A\ell_2O_3$ | Graphite |
|---|---|---|---|
| Velocity v(m/s) | 148 | 200 | 400 |

The pulse period $\tau$ is 3.6 ms and the laser energy E is 36.5 J/P from a YAG laser. As shown in Table 1, the movement velocity is the highest in the case of graphite. Therefore, exposure of a base material (a target) to the plume generated in the case of graphite makes it possible to form a film of ultrafine particles.

In order to produce desired ultrafine particles, a predetermined gas is introduced into the ultrafine-particle film forming chamber 5 through an atmosphere gas supplying pipe 9. The opening of this supply pipe 9 is in the vicinity of the bottom of the film forming chamber 5 and at substantially the same height as the raw material 6, and a gas supplied flows out in the direction of the plume 8. A gate valve 10 is provided on the supply pipe 9. On the other side of the film forming chamber 5, an exhaust pump 11 is provided for internal evacuation of the film forming chamber 5, and a gate valve 10 is provided on the flow path thereof. The atmosphere pressure is controlled by means of the exhaust pump 11. As the atmosphere gas, a predetermined gas is supplied after the ultrafine-particle film forming chamber 5 is evacuated to a vacuum of about 9133 Pa ($10^{-3}$ Torr).

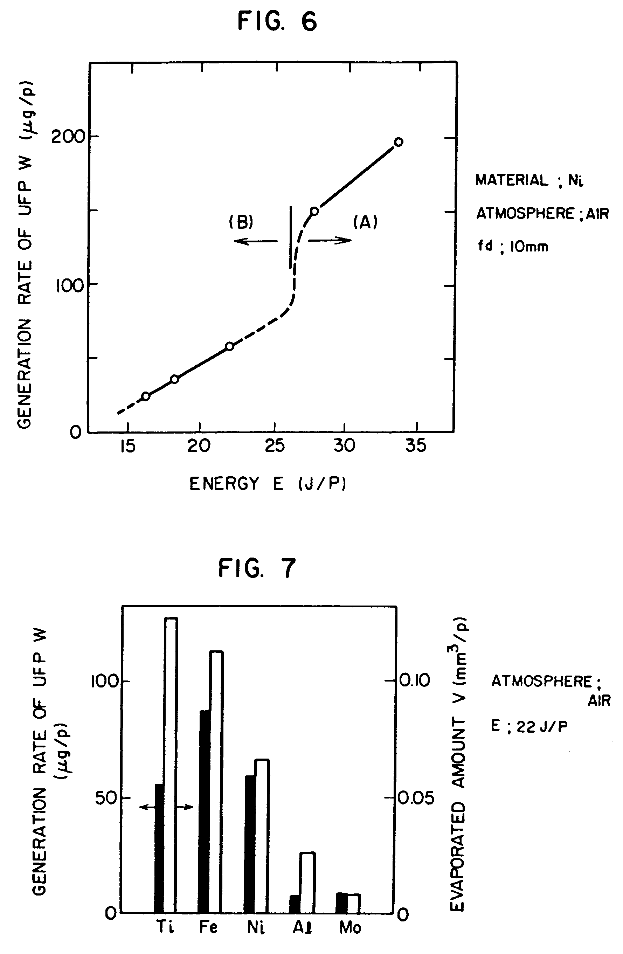

Fig. 6 illustrates the relationship between the applied energy E and the generation rate of ultrafine particles w. Ultrafine particles can be produced most efficiently by irradiation with energy in the region (B) in which energy is slightly lower than in the region (A) where sparks are generated concomitantly. Conditions under which this data was obtained were as follows: nickel (Ni) was used as the raw material 6, air was used as the atmosphere gas, and the distance from focus $f_d$ was adjusted to 10 mm.

On the other hand, in Fig. 7 is shown the generation rate W and the evaporated amount V in the case of irradiation of each of various raw materials [titanium (Ti), iron (Fe), nickel (Ni), aluminum ($A\ell$) and molybdenum (Mo)] with a predetermined amount of energy. The applied energy E was 22 J/P, the atmosphere gas was argon, and $f_d$ was 10 mm. As shown in Fig. 7, the relationship between the generation rate W and the evaporated amount V varies depending on physical properties of the raw materials (surface absorption energy, heat conductivity, evaporation temperature, melting point, etc.). In Fig. 7, the black bars refers to the weight loss, i.e., the generation rate, and the white bars to the evaporated amount. Therefore, it is recommendable to conduct the irradiation by selecting energy conditions where the plume phenomenon occurs most vigorously, depending on the kind and surface condition of raw material, atmosphere gas, atmosphere pressure, the kind and wavelength of laser, the kind of optical system, the kind of glass plate, etc.

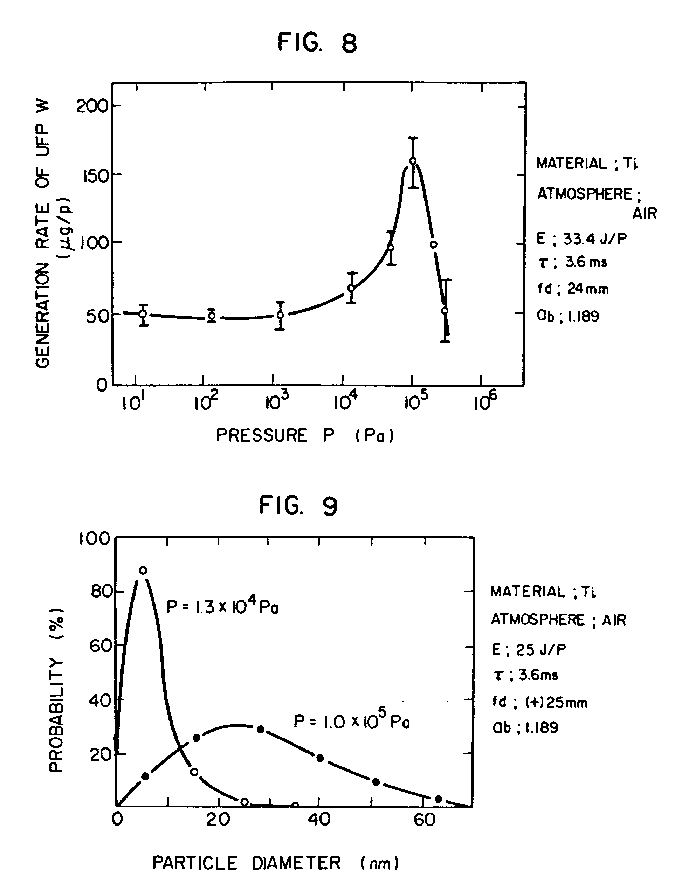

For example, in the relationship between atmosphere pressure and generation rate in the case of using titanium (Ti) as raw material, the generation rate is the highest, as shown in Fig. 8, when the atmosphere pressure is $10^5$ Pa which is close to atmospheric pressure. The atmosphere gas was air, and the applied energy E, the pulse $\tau$, $f_d$ and $a_b$ were adjusted to 33.4 J/P, 3.6 ms, 24 mm and 1.189, respectively. From Fig. 8 and Fig. 4, it can be seen that when the atmosphere pressure is $5 \times 10^5$ Pa or less, the propagation velocity of the top of plume and the generation rate are high.

As shown in Fig. 9, the particle diameter distribution of ultrafine particles shows a particle diameter range of 5 to 65 nm when the atmosphere pressure P is $10^5$ Pa. On the other hand, when the atmosphere pressure is as low as $1.3 \times 10^4$ Pa, the generation rate is somewhat decreased but ultrafine particles

EP 0 265 886 B1

uniform in particle diameter (5 nm) can be obtained. In Fig. 9, the raw material 6 is Ti; the atmosphere gas is air; E, $\tau$, $f_d$ and $a_b$ are 25 J/P, 3.6 ms, +25 mm and 1.189, respectively; and the axis of ordinate refers to the probability of generation.

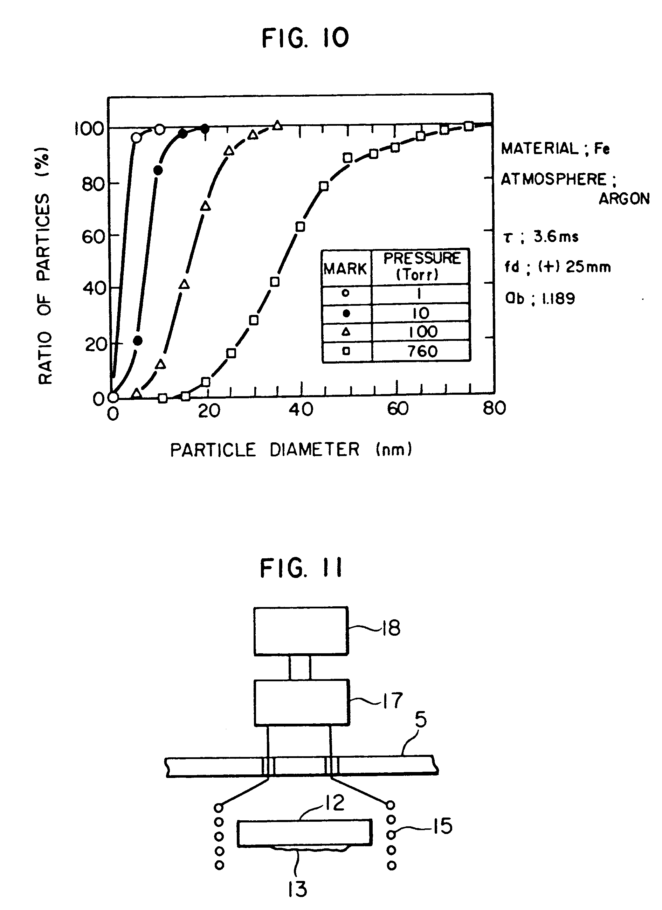

In Fig. 10 are shown data obtained when iron (Fe) was used as raw material and argon was used as atmosphere gas in place of air. It can be seen from Fig. 10 that irrespective of the kind of atmosphere gas, the lower the atmosphere pressure, the smaller (for example, 15 nm) and more uniform the particle diameter. From Fig. 9 and Fig. 10, it is clear that the particle diameter distribution of an ultrafine-particle film can be controlled by means of the atmosphere pressure.

As shown in Table 2, production of ultrafine particles by laser irradiation is possible in the case of almost all metal materials, and it is possible also in the case of nonmetals and alloys. In the case of an alloy, the composition of the resulting ultrafine particles tends to be somewhat different from that of the alloy.

Since the ultrafine particles produced are in a very active state, it becomes possible to produce various ceramic ultrafine particles (compound ultrafine particles) by direct chemical reaction of a plume and an atmosphere gas. In Tabel 2 are also listed examples of oxides produced in an oxygen gas atmosphere and examples of nitrides produced in a nitrogen gas atmosphere.

Table 2

| Starting metal | | Ultrafine particles (type) | | |
|---|---|---|---|---|
| | | Air | Oxygen gas | Nitrogen gas |
| IA | Cu | Cu(fcc) | | |
| IIA | Zn | Zn(hcp) | ZnO | Zn(hex) |
| IIIA | A$\ell$ | A$\ell$(fcc) | A$\ell_2$O$_3$ ($\gamma$-, $\delta$-) | A$\ell$(fcc), A$\ell$N(hex) |
| IVA | Si | Si(dia) | Si(amorphous) | Si(dia) |
| | Sn | $\beta$-Sn(tetra) | SnO$_2$ | $\beta$-Sn, (SnO) (tetra) |
| | Pb | Pb(fcc) | $\alpha$-PbO$_2$ + PbO | Pb(fcc) |
| IVB | Ti | $\alpha$-Ti(hcp) | TiO$_2$ (anatase + rutile) | TiN(NaC$\ell$) |
| | Zn | $\alpha$-Zr(hcp) | ZrO$_2$(Cubic + tetra + monoclinic) | ZrN(NaC$\ell$) |
| VB | V | V(bcc) | V(amorphous) | VN(NaC$\ell$) |
| | Nb | Nb(bcc) | Nb$_2$O$_5$ | Nb$_4$N$_3$(tetra) |
| | Ta | Ta(bcc) | -Ta$_2$O$_5$ | Ta$_2$N(hex) |
| VIB | Cr | Cr(bcc) | Cr$_2$O$_3$ | $\beta$-Cr$_2$N(hex) |
| | Mo | Mo(bcc) | $\eta$-MoO$_3$ | Mo(bcc) |
| | W | W(bcc, $\beta$-), W$_3$O | WO$_3$ | W(bcc, $\beta$-), W$_3$O |
| VIIB | Mn | $\beta$-Mn(cubic) | r-Mn$_2$O$_3$ | Mn(cubic), Mn$_4$N(hex) |
| VIII | Fe | $\alpha$-Fe(bcc) | Fe$_2$O$_3$ ($\gamma$-, $\epsilon$-) | $\alpha$-Fe(bcc) |
| | Co | Co(fcc), CoO | CoO | Co(fcc), CoO |
| | Ni | Ni(fcc) | NiO | Ni(fcc) |

Furthermore, ultrafine particles of a mixture of metal and ceramic can be produced by irradiating an alloy material with laser energy in a reactive gas atmosphere. For example, when a Fe - Ti alloy or a Ni - Ti alloy is irradiated with laser energy in a nitrogen gas atmosphere, the former alloy gives ultrafine particles of a mixture of Fe and TiN while the latter alloy gives ultrafine particles of a mixture of Ni and TiN. Since a part of atmosphere gas is dissociated by laser energy or energy usable together therewith such as arc energy or energy of plasma generated, as shown in Fig. 11, by means of a high-frequency induction coil 15, carbide ultrafine particles can be produced using gases other than N$_2$ gas and O$_2$ gas such as methane (CH$_4$), acetylene (CH≡CH), Freon (CC$\ell_2$F$_2$), propane (C$_3$H$_8$), butane (C$_4$H$_{10}$), etc. In addition to hydrocarbon gases, ammonia (NH$_3$), etc. can also be used. Thus, desired compound ultrafine particles of an oxide, nitride or carbide can be produced by selecting a suitable gas. Furthermore, compound ultrafine particles

6

can similarly be obtained also by irradiating these compounds (ceramics) directly with laser energy. As a source of the energy used in this invention, there can be used, besides YAG laser, lasers on other oscillation methods such as $CO_2$ laser, dye laser, etc.

FILM FORMING STEP

As described above, when the plume 8 is generated, ultrafine particles are produced and at the same time, more upward at a high speed. Therefore, when a base material or substrate 12 is placed in their path, namely, in the direction of the top of the plume 8, the ultrafine particles collide therewith and accumulate thereon, whereby an ultrafine-particle film 13 can be formed.

Although in Fig. 1, the base material 12 is heated by means of a heater 14, a high-frequency induction coil 15 may be used as shown in Fig. 11. In addition to these heat sources, optical beams, lasers, etc. can also be used as heat sources. In Fig. 1 and Fig. 11, the symbol 16 shows an electric source for heater, the symbol 17 a matching device, and the symbol 18 an electric source of high frequency.

As described above, under conditions where a plume is generated, ultrafine particles move to the base material or substrate at a high speed simultaneously with their production, and hence an ultrafine-particle film of high purity can easily be obtained.

This invention is applicable to production of powder of an oxide superconducting material of ceramic or formation of a film of said material.

For example, an ultrafine-particle film of oxide superconducting material can be formed on the surface of a substrate by generating a plume in an atmosphere of oxygen, oxygen and an inert gas, oxygen and a fluoride gas, or the like by using as the raw material 6 an alloy (e.g., a Y-Ba-Cu alloy) which is such that an ultrafine-particle film formed by irradiating the alloy with the laser energy 2 has a predetermined composition as superconducting material (e.g., $YBa_2Cu_3O_{7-8}$). It is also possible to generate a plume, for example, in an inert atmosphere or an oxygen-containing atmosphere by using as raw material a sintered body of oxide superconductor having the corresponding composition.

Furthermore, it is also possible to obtain a desired superconducting material in the following manner. Each of metals (Y, Ba, Cu, etc.) which are to constitute a final product or each of compounds thereof ($Y_2O_3$, $BaCO_3$, CuO, etc.) is irradiated with laser energy for a predetermined period of time to generate a plume, and the superconducting material is obtained while mixing the thus generated plumes during their movement to the base material, or substrate.

When the atmosphere gas is ionized by means of the high-frequency induction coil 15 shown in Fig. 11, the reaction proceeds more effectively.

The film formed in the manner described above can be made into a high-temperature superconducting film on-line without exposure to the atmosphere, by using an inert gas, oxygen, oxygen and an inert gas, oxygen and a fluoride gas, or the like as the atmosphere gas in the film-forming chamber 5, and heating the film by means of the high-frequency induction coil 15 to heat-treat the same (for example, in the case of $YBa_2Cu_3O_{7-8}$ superconducting material, a starting alloy is heated in an oxygen gas atmosphere at 900° to 1050°C for 5 hours and then cooled at a rate of 200°C/Hr).

The sintered body used as raw material is, for example, a sintered body of calcined oxide superconductor powder. This sintered body is produced, for example, by a co-precipitation method, and specifically, it is a sintered body of $Y_{0.4}Ba_{0.6}CuO_3$ powder.

Furthermore, for example, a La-Ba-Cu-O series superconducting thin film can be formed in an argon gas atmosphere in consideration of irradiation time by using suitable oxides (or carbonate in the case of Ba) of the individual constituent metal clements.

**Claims**

1. A process for forming an ultrafine particle film on a substrate,
   - wherein the surface of a raw material is irradiated with laser energy from $10^4$ to $10^7$ W/cm$^2$ in a predetermined atmosphere having a pressure of $1.3 \cdot 10^4$ to $5 \cdot 10^5$ Pa,
   - wherein a plume-shaped high-speed stream of shining high-density vapour of metal or other material is generated, in which stream the ultrafine particles condense with a particle size of 5 to 65 nm, and
   - wherein the substrate is exposed to said stream
   - whereby the film of ultrafine particles is formed on said substrate.

2. A process according to claim 1, wherein the substrate is previously heated.

EP 0 265 886 B1

3. A process according to claim 1 or 2, wherein said predetermined atmosphere includes a gas component which is reacted with said plume-shaped stream of vapour and/or an intermediate product of the film formation or said film, whereby a desired compound or alloy film is obtained on said substrate.

4. A process according to one of the claims 1 to 3, wherein a raw material for oxide superconductor is used for forming a film of superconducting material on said substrate.

5. A process according to claim 4, wherein in the film formation said film is cooled with 200° C/h after being heated.

6. A process according to claim 5, wherein heating is carried out by using a heater or a high-frequency induction coil.

**Patentansprüche**

1. Verfahren zur Ausbildung eines Films aus ultrafeinen Teilchen auf einem Substrat, bei welchem
   - die Oberfläche eines Rohmaterials mit Laserenergie von $10^4$ bis $10^7$ W/cm$^2$ in einer vorher festgelegten Atmosphäre bestrahlt wird, die einen Druck von $1,3 \cdot 10^4$ bis $5 \cdot 10^5$ Pa hat,
   - ein federförmiger Hochgeschwindigkeitsstrom aus leuchtendem Hochdruckdampf eines Metalls oder eines anderen Materials erzeugt wird, in welchem die ultrafeinen Teilchen mit einer Teilchengröße von 5 bis 65 nm kondensieren, und
   - das Substrat dem Strom ausgesetzt wird,
   - wobei der Film aus ultrafeinen Teilchen auf dem Substrat ausgebildet wird.

2. Verfahren nach Anspruch 1, bei welchem das Substrat vorerhitzt wird.

3. Verfahren nach Anspruch 1 oder 2, bei welchem die vorgegebene Atmosphäre eine Gaskomponente hat, die mit dem federförmigen Strom des Dampfes und/oder einem Zwischenprodukt der Filmbildung oder dem Film reagiert hat, wodurch ein gewünschter Verbindungs- oder Legierungsfilm auf dem Substrat erhalten wird.

4. Verfahren nach einem der Ansprüche 1 bis 3, bei welchem ein Rohmaterial für Oxydsupraleiter zur Bildung eines Films aus supraleitendem Material auf dem Substrat verwendet wird.

5. Verfahren nach Anspruch 4, bei welchem bei der Filmbildung der Film mit 200° C/h, nachdem er erhitzt worden ist, abgekühlt wird.

6. Verfahren nach Anspruch 5, bei welchem das Erhitzen unter Verwendung einer Heizeinrichtung oder einer Hochfrequenzinduktionsspule ausgeführt wird.

**Revendications**

1. Procédé pour préparaton d'un film formé de particules ultra-fines sur un substrat,
   - dans lequel on irradie la surface d'une matière première avec une énergie de laser de $10^4$ à $10^7$ W/cm$^2$ dans une atmosphère prédéterminée ayant une pression de $1,3 \times 10^4$ à $5 \times 10^5$ Pa,
   - dans lequel on génère un courant à grande vitesse en forme de panache de vapeur brillante à haute densité constitué de métal ou d'autre matière, dans lequel courant, les particules ultra-fines se condensent en particules de taille de 5 à 65 nm, et
   - dans lequel le substrat est exposé audit courant,
   - de sorte que le film de particules ultra-fines se forme sur ledit substrat.

2. Procécé selon la revendication 1, dans lequel le substrat est préalablement chauffé.

3. Procédé selon la revendication 1 ou 2, dans lequel ladite atmosphère prédéterminée inclut un composant gazeux que l'on fait réagir avec ledit courant de vapeur en forme de panache et/ou un produit intermédiaire dans la formation du film ou ledit film de sorte que l'on obtient un film composé ou d'alliage désiré sur ledit substrat.

8

**4.** Procédé selon l'une des revendications 1 à 3, dans lequel on utilise une matière première d'oxyde supra-conducteur dans le but de former un film de matière supraconductrice sur ledit substrat.

**5.** Procédé selon la revendication 4, dans lequel pendant la formation de la couche mince, cette dernière est refroidie à raison de 200°C/h après avoir été chauffée.

**6.** Procédé selon la revendication 5, dans lequel on procède au chauffage en utilisant un appareil de chauffage ou une bobine d'induction à haute fréquence.

FIG. 1

## FIG. 2

MATERIAL ; Ti

PRESSURE ; $1,013 \cdot 10^5$ Pa

ATMOSPHERE ; AIR

$\tau$ ; 3.6 ms

f ; 127 mm

## FIG. 3

MATERIAL ; Ti

PRESSURE ; $1,013 \cdot 10^5$ Pa

ATMOSPHERE ; AIR

$\tau$ ; 3.6 ms

E ; 36.5 J/P

11

FIG. 4

FIG. 5

## FIG. 6

MATERIAL ; Ni

ATMOSPHERE ; AIR

fd ; 10mm

## FIG. 7

ATMOSPHERE ;
                    AIR

E ; 22 J/P

## FIG. 8

MATERIAL ; Ti

ATMOSPHERE ;
AIR

E ; 33.4 J/P

$\tau$ ; 3.6 ms

fd ; 24 mm

ab ; 1.189

## FIG. 9

MATERIAL ; Ti

ATMOSPHERE ; AIR

E ; 25 J/P

$\tau$ ; 3.6ms

fd ; (+)25mm

ab ; 1.189

14

EP 0 265 886 B1

## FIG. 10

MATERIAL ; Fe

ATMOSPHERE ; ARGON

$\tau$ ; 3.6 ms

fd ; (+) 25 mm

ab ; 1.189

| MARK | PRESSURE (Torr) |
|------|-----------------|
| ○ | 1 |
| ● | 10 |
| △ | 100 |
| □ | 760 |

## FIG. 11

15